# EUROPÄISCHE PATENTSCHRIFT

(11) **EP 1 247 250 B1**
(45) Veröffentlichungstag und Bekanntmachung des Hinweises auf die Patenterteilung: **03.03.2004**
(21) Anmeldenummer: 00991117.3
(22) Anmeldetag: 27.12.2000
(51) Int. Cl.: G06K 19/00

(54) **CHIPKARTENANORDNUNG**
CHIPCARD ARRANGEMENT
ENSEMBLE CARTE A PUCE

(30) Priorität: 11.01.2000 EP 00100507
(43) Veröffentlichungstag der Anmeldung: 09.10.2002
(73) Patentinhaber: Infineon Technologies AG, 81669 München (DE)
(72) Erfinder: KUX, Andreas, 85540 Haar (DE)
(74) Vertreter: Epping Hermann & Fischer
(86) Internationale Anmeldenummer: PCT/DE2000/004634
(87) Internationale Veröffentlichungsnummer: WO 2001/052184

(56) Entgegenhaltungen:
- WO-A-94/25982
- DE-A- 19 735 170
- DE-C- 19 511 775
- DE-C- 19 702 121

## Beschreibung

Die Erfindung betrifft eine Chipkartenanordnung mit einem kartenförmigen Träger, in dem eine Ausnehmung vorgesehen ist, die zur Aufnahme eines Halbleiterchips dient.

Derartige Chipkartenanordnungen sind mittlerweile weit verbreitet. Sie werden beispielsweise als bargeldloses Zahlungsmittel, als Telefonkarte, als Kreditkarte oder als Speicher für persönliche Daten, wie beispielsweise bei der Krankenkassen-Chipkarte, verwendet. Die Chipkarten sind dabei den unterschiedlichsten äußeren Einflüssen unterworfen. Insbesondere können Biegebeanspruchungen auftreten, die im Extremfall die Funktionsfähigkeit der Chipkarte beeinträchtigen können.

Üblicherweise besteht eine Chipkarte aus einem kartenförmigen Träger, in dem eine Ausnehmung vorgesehen ist. In diese wird ein Modul, bestehend aus einem Trägerelement, auf welchem ein Halbleiterchip angeordnet ist, und einem Kontaktelement, das eine elektrische Kontaktierung von außen ermöglicht, eingesetzt. Die elektrische Verbindung zwischen dem Halbleiterchip und den Kontaktelementen wird über Bond-Drähte realisiert. Das Modul dient dazu, den Halbleiterchip vor mechanischen Beschädigungen zu schützen und einen einfachen Zusammenbau des kartenförmigen Trägers mit dem Modul zu ermöglichen.

In der Vergangenheit hat sich ein Standard (ISO-Standard) herausgebildet, der die Abmasse des Moduls und die Anordnung der Kontaktelemente bestimmt. Die Abmasse des Moduls sind im wesentlichen von der Größe des Halbleiterchips abhängig. Die Größe des Halbleiterchips, die eine Fläche von 20 bis 25 mm² nicht überschreitet, ist durch die geforderte Bruchfestigkeit des Halbleiterchips bedingt. Würde die Fläche des Halbleiterchips größer ausgeführt werden, so könnte durch auftretende Biegebelastungen an der Chipkarte, die dann auch auf das Modul übertragen werden, der Halbleiterchip beschädigt werden.

Durch die Flächenbegrenzung ist das Maß der Komplexität bzw. der auf dem Halbleiterchip realisierbaren Funktionen beschränkt. Da die Einsatzgebiete und der Funktionsumfang einer Chipkarte in Zukunft stärker zunehmen werden, besteht das Bedürfnis, möglichst viele Bauelemente auf dem Halbleiterchip unterzubringen. Durch die Flächenbegrenzung kann die Anzahl der Funktionen bzw. der Bauelemente jedoch nicht beliebig erweitert werden.

Zur Lösung dieses Problems schlägt die DE 195 11 775 C1, gegen die die Ansprüche abgegrenzt wurden, ein Trägermodul zum Einbau in einem kartenförmigen Datenträger vor, das zumindest zwei Halbleiterchips aufweist, die auf einem Trägerelement des Trägermoduls angeordnet sind und elektrisch mit dem Kontaktelement des Moduls verbindbar sind. Die Halbleiterchips sind dabei übereinander angeordnet. Der direkt auf dem Trägerelement angeordnete erste Halbleiterchip weist eine größere Fläche als der auf dem ersten Halbleiterchip befestigte zweite Halbleiterchip. Diese Vorgehensweise ist dadurch bedingt, daß der erste Halbleiterchip auf der von dem Trägerelement abgewandten Oberfläche Kontaktpads aufweist, die über Bond-Drähte mit dem Trägerelement des Trägermoduls verbunden sind. Der zweite Halbleiterchip weist ebenfalls auf seiner Oberfläche Kontaktpads auf, die in einer Variante über Bond-Drähte mit dem Kontaktelement verbunden sind. Nachteilig bei einer derartigen Anordnung ist, daß Signale über die Bonddrähte von den Halbleiterchips abgegriffen werden können, wodurch sicherheitsrelevante Daten nicht ausreichend geschützt sind.

Da bei einer Bond-Verbindung grundsätzlich bestimmte BiegeRadien nicht unterschritten werden dürfen, muß das Trägermodul eine bestimmte Mindesthöhe aufweisen. Es ist deshalb fraglich, ob die nach dem ISO-Standard vorgegebenen Abmasse eines derartigen Trägermoduls eingehalten werden können. Weiterhin weist das in der DE 195 11 775 C1 beschriebene Trägermodul den Nachteil auf, daß trotz zweier übereinander gestapelter Halbleiterchips die Integrationsdichte nicht verdoppelt werden konnte.

Die DE 197 02 121 C1 beschreibt ein Verfahren zur Herstellung vertikaler Chipverbindungen, indem zwei Chips übereinander angeordnet und befestigt werden und über Substratöffnungen elektrisch leitend verbunden werden.

In der WO 94 25982 A ist eine Kontaktstrukturierung übereinander angeordneter Chips mittels vertikaler Metallstifte beschrieben.

In der DE 197 35 170 A ist ein Modul mit nebeneinander angeordneten Halbleiterchips offenbart.

Die Aufgabe der vorliegenden Erfindung besteht nunmehr darin, eine Chipkartenanordnung vorzusehen, die eine hohe Integrationsdichte aufweist und gleichzeitig einen hohen Schutz der Daten ermöglicht.

Diese Aufgabe wird mit den Merkmalen des Patentanspruchs 1 gelöst.

Die Aufgabe wird dadurch gelöst, daß der erste Halbleiterchip im Bereich einer ersten Hauptfläche mindestens ein erstes Halbleiterbauelement mit der ersten Verbindung und der zweite Halbleiterchip (5) im Bereich einer zweiten Hauptfläche mindestens ein zweites Halbleiterbauelement mit der zweiten Verbindung aufweist, wobei der erste und der zweite Halbleiterchip so zu einem Stapel zusammengefügt sind, daß die erste Hauptfläche auf die zweite Hauptfläche trifft, so daß mindestens eine erste Verbindung und eine zweite Verbindung aufeinandertreffen und zusammen eine dreidimensionale Verdrahtung innerhalb des Stapels ausbilden und die zumindest zwei Halbleiterchips zusammen eine Mindestgröße von 20 mm² aufweisen.

Hierdurch kann auf die Verwendung von Bond-Drähten verzichtet werden, die einerseits Kontaktpads auf einer Oberfläche jedes Halbleiterchips erfordern und andererseits eine vorgegebene Mindestbauhöhe der Chipkartenanordnung erfordert. Durch das Vorsehen einer dreidimensionalen Verdrahtung in den Halbleiterchips kann die Chipkartenanordnung gegenüber dem Stand der Technik mit geringerer Bäuhöhe realisiert werden.

Dadurch, daß die zumindest zwei Halbleiterchips zusammen eine Mindestgröße von 20 aufweisen, die die maximal mögliche Fläche eines einzelnen Halbleiterchips bezüglich der Biegebeanspruchung darstellt, kann die Integrationsdichte gegenüber dem Stand der Technik wesentlich erhöht werden. Insbesondere ermöglicht die Erfindung die weitere Verwendung von Standardmodulen, die auf eine Chipgrundfläche von 20 bis 25 mm² ausgelegt sind.

Vorteilhafte Ausgestaltungen ergeben sich aus den Unteransprüchen.

Selbstverständlich könnte das erste Bauelement auch auf der der ersten Hauptfläche gegenüberliegenden Seite des ersten Halbleiterchips zum Liegen kommen. Entsprechend könnte die Anordnung von zweiten Kontakten und zweiten Bauelementen auch bei dem zweiten Halbleiterchip sein. Eine derartige Anordnung erhöht die Sicherheit gegen einen unerwünschten Signalabgriff.

In der der ersten Hauptfläche gegenüberliegenden Rückseite des ersten Halbleiterchips sind in eine weiteren Ausgestaltung Kontaktlöcher zur Bildung von Rückseitenkontakten vorgesehen, die mit elektrischen Anschlüssen des kartenförmigen Trägers verbunden sind. Da auch die elektrische Kontaktierung der Halbleiterchips mit den elektrischen Anschlüssen des kartenförmigen Trägers in einer vertikalen Ebene stattfindet, bleibt gegenüber dem Stand der Technik mit einer Drahtbondung in der Ausnehmung ein ungenützter freier Raum, der eine Vergrößerung der Halbleiterchips zuläßt, ohne die Abmasse der Ausnehmung bzw. eines Trägermoduls verändern zu müssen. Ist ausreichend Platz in der Ausnehmung vorhanden, könnte alternativ selbstverständlich auch eine Bondverbindung zwischen einem der Halbleiterchips und den elektrischen Anschlüssen des kartenförmigen Trägers vorgesehen sein, sofern sichergestellt ist, daß über diese elektrischen Anschlüsse keine sicherheitsrelevanten Daten übertragen werden.

Eine Vergrößerung jedes einzelnen der Halbleiterchips über die bisher vorhandene Flächenlimitierung von 20 bis 25 mm² kann dadurch erfolgen, daß die übereinanderliegenden Halbleiterchips auf ihren jeweiligen Rückseiten dünn geschliffen werden. Je dünner ein Halbleiterchip ausgeführt ist, desto höher ist seine Biegefähigkeit, ohne daß Beschädigungen im Inneren des Halbleiterkörpers auftreten.

Zudem ist es möglich, bis zu sieben Halbleiterchips in einem Standard-ISO-Modul anzuordnen, während bei einer üblichen Bondverbindung maximal drei Halbleiterchips übereinander möglich sind. Andererseits kann ein Modul wesentlich dünner gebaut werden, indem eine dreidimensionale Verdrahtung rückseitengedünnter **Halbleiterchips** vorgesehen ist. Hierbei würden lediglich die Anzahl an Halbleiterchips übereinander angeordnet werden, die für die Realisierung der Funktionen notwendig sind.

In einer vorteilhaften Ausgestaltung ist die Funktionsfähigkeit der Chipkartenanordnung nur dann gewährleistet, wenn die zumindest zwei Halbleiterchips elektrisch miteinander verbunden sind. Diese Vorgehensweise ist insbesondere bei sicherheitsrelevanten Anwendungen von Vorteil, da die elektrischen Anschlüsse des ersten Halbleiterchips, der zwischen den kartenförmigen Träger und den zweitem Halbleiterchip gelegen ist, nicht von außen kontaktierbar sind. Würden die ersten Kontakte des ersten Halbleiterchips freigelegt, so müßten die Verbindungen zwischen den ersten Kontakten und den zweiten Kontakten aufgetrennt werden. Hierdurch werden die auf den Halbleiterchips realisierten Schaltungen nicht mehr funktionieren und somit eine Untersuchung der auf den Leitungen entstehenden Ladungspotentialen verhindern.

Vorteilhafterweise weisen die übereinander liegenden Halbleiterchips eine maximale Höhe von 200µm auf.

In einer weiteren Ausgestaltung sind die übereinanderliegenden Halbleiterchips in einem Modul mit einem Kontaktelemente aufweisenden Trägerelement angeordnet und elektrisch mit den Kontaktelementen verbunden. Das Modul ist dabei in die Ausnehmung des kartenförmigen Trägers eingebracht. Das Vorsehen eines Moduls, welches in die Ausnehmung des kartenförmigen Trägers eingebracht wird, entspricht dem üblichen Aufbau einer Chipkarte. Somit ist eine einfache und kostengünstige Fertigung der erfindungsgemäßen Chipkartenanordnung möglich.

Weitere Einzelheiten und Vorteile der Erfindung ergeben sich aus den nachfolgenden Figurenbeschreibungen und Ausführungsbeispielen. Es zeigen:
- Figur 1: den prinzipiellen Aufbau einer aus dem Stand der Technik bekannten Chipkarte in einer Draufsicht,
- Figur 2: einen Querschnitt der Chipkartenanordnung aus Figur 1,
- Figur 3: eine erste beispielhafte Anordnung der Halbleiterchips in einem Modul,
- Figur 4: eine zweite beispielhafte Anordnung der Halbleiterchips in einem Modul,
- Figur 5: einen Querschnitt durch zwei Halbleiterchips, in welchem das Prinzip der dreidimensionalen Verdrahtung veranschaulicht wird und
- Figur 6: drei übereinander liegende Halbleiterchips, die mittels einer dreidimensionalen Verdrahtung miteinander elektrisch verbunden sind.

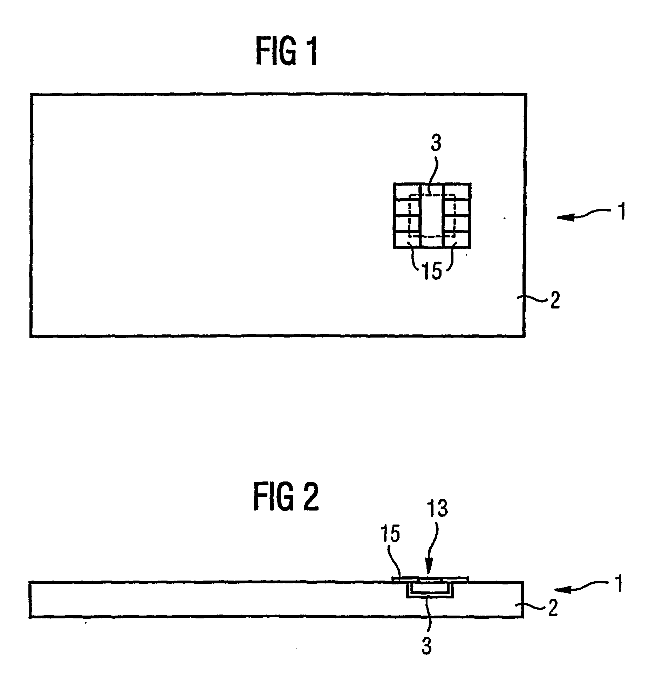

Figur 1 zeigt eine aus dem Stand der Technik bekannte Chipkartenanordnung 1 in einer Draufsicht. Die Chipkartenanordnung 1 weist einen kartenförmigen Träger 2 auf, welcher auf einer Hauptfläche eine Ausnehmung 3 aufweist. Die Ausnehmung 3 ist in der Figur 1 gestrichelt dargestellt. In die Ausnehmung 3 wird ein Modul (nicht sichtbar) eingebracht, welches im wesentlichen aus einem Trägerelement, dem Halbleiterchip (beide nicht sichtbar) und einem Kontaktelement 15 besteht. Über das Kontaktelement 15, das im ISO-Standard acht voneinander separierte Kontaktflächen aufweist, ist die elektrische Verbindung zu einem externen Lese-/Schreibgerät möglich.

Figur 2 zeigt einen Querschnitt durch die Chipkartenanordnung 1, welche in Figur 1 dargestellt ist. Der kartenförmigen Träger 2, der im vorliegenden Ausführungsbeispiel aus einer einzigen Lage besteht, weist eine Ausnehmung 3 auf. In die Ausnehmung 3 ist das Modul 13 eingebracht. Das zu dem Modul 13 gehörige Kontaktelement 15 kommt dabei auf der Oberseite des kartenförmigen Trägers 2 zum Liegen und ragt über den Rand der Ausnehmung 3 hinaus. Die Ausgestaltung des kartenförmigen Trägers 2 ist dabei nicht auf eine Lage, wie dargestellt, beschränkt. Der kartenförmigen Träger 2 könnte aus einer beliebigen Anzahl aus übereinander liegenden Lagen bestehen.

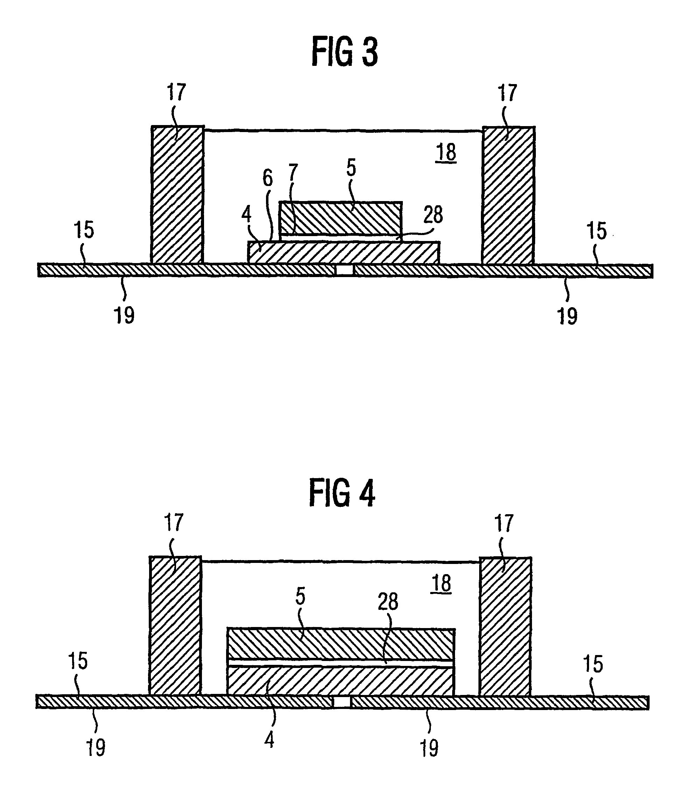

Figur 3 zeigt in einem ersten Ausführungsbeispiel ein Modul, welches zum Einbringen in die Ausnehmung eines kartenförmigen Trägers gemäß der Erfindung gedacht ist. Das Modul weist ein Kontaktelement 15 auf, das über Kontaktflächen 19 von außen kontaktierbar ist. Auf der von den Kontaktflächen 19 abgewandten Seite befindet sich ein erster Halbleiterchip 4. Dieser ist mit seiner Rückseite auf dem Kontaktelement 15 angeordnet. Auf einer ersten Hauptfläche 6 ist ein zweiter Halbleiterchip 5 mit einer zweiten Hauptfläche 7 angeordnet. Der erste Halbleiterchip 4 weist eine größere Fläche als der zweite Halbleiterchip 5 auf. Die Fläche des zweiten Halbleiterchips 5 kann dabei 20 bis 25 mm² betragen, während die Fläche des ersten Halbleiterchips 4 größer ist. Der zweite Halbleiterchip könnte auch größer als die angegebene Fläche sein.

Der erste Halbleiterchip 4 und der zweite Halbleiterchip 5 sind beispielsweise über eine Haftschicht 28 miteinander verbunden. Die elektrische Verbindung zwischen dem ersten und dem zweiten Halbleiterchip 4, 5 findet über eine dreidimensionale Verdrahtung statt, die in den nachfolgenden Figuren noch näher erläutert wird.

Die Erfindung sieht im vorliegenden Ausführungsbeispiel ebenfalls vor, daß die elektrische Verbindung zwischen dem ersten Halbleiterchip 4 und dem Kontaktelement 15 nicht über Bond-Drähte, sondern ebenfalls über eine dreidimensionale Verdrahtung stattfindet.

Zur mechanischen Stabilisierung des Moduls sind die Halbleiterchips 4, 5 von einem Versteifungsring 17 umgeben. Der von dem Versteifungsring 17 und dem Kontaktelement 15 umschlossene Raum, in welchem sich die Halbleiterchips 4, 5 befinden, kann beispielsweise mit einer Vergußmasse ausgefüllt sein, um die Halbleiterchips vor einer mechanischen Beschädigung zu schützen. Es wäre gleichfalls vorstellbar, daß auf dem Versteifungsring 17 ein Deckel aufgebracht wird und der gebildete Hohlraum ohne eine Vergußmasse verbleibt.

Eine Vergrößerung des ersten Halbleiterchips 4 über die bisher maximale Fläche von 20 bis 25 mm² ist dadurch möglich, daß der erste Halbleiterchip 4 gegenüber dem zweiten Halbleiterchip 5 eine wesentlich geringere Dicke aufweist. Hierdurch verringert sich bei einer Verbiegung die mechanische Belastung. Eine Vergrößerung gegenüber den genannten ursprünglichen Abmassen ist dadurch möglich, daß durch die dreidimensionale Verdrahtung zwischen dem Rand des Halbleiterchips 4 und dem Versteifungsring 17 ein nichtgenutzter Raum verbleibt, der im Stand der Technik für ein Bond-Verbindung benötigt wird. Im Extremfall ist es vorstellbar, daß der erste Halbleiterchip 4 bis an den Versteifungsring 17 heranreicht.

In der Figur 3 ist beispielhaft eine Anordnung gezeigt, die aus zwei übereinanderliegenden Halbleiterchips besteht. Prinzipiell ist es auch denkbar, mehr als zwei Halbleiterchips übereinander zu stapeln, sofern gewährleistet ist, daß die übereinander liegenden Halbleiterchips eine Höhe von 200µm nicht überschreiten. Das Vorsehen einer Vielzahl an übereinander liegenden Halbleiterchips ist in der Praxis problemlos möglich, da bei einer dreidimensionalen Verdrahtung ein Dünnschleifen derjenigen Halbleiterchips prinzipiell vorgesehen ist, die sowohl auf ihrer ersten Hauptfläche als auch auf ihrer Rückseite Kontakte aufweisen.

Figur 4 zeigt ein zweites Ausführungsbeispiel der Anordnung der Halbleiterchips in einem Modul 13. Dieses unterscheidet sich von der Anordnung aus Figur 3 lediglich dadurch, daß der erste und der zweite Halbleiterchip 4, 5 eine identische Grundfläche aufweisen. Der erste Halbleiterchip 4 und der zweite Halbleiterchip 5 sind derart übereinanderliegend, daß deren Ränder bündig übereinander zum Liegen kommen. Weisen der erste und der zweite Halbleiterchip 4, 5 die bisher übliche Fläche von 20 bis 25 mm² auf, so verbleibt zu den Versteifungsring 17 ein relativ großer ungenützter Bereich. Durch ein Rückseitenschleifen sowohl des ersten als auch des zweiten Halbleiterchips 5 kann dieser Bereich für eine Vergrößerung der Chipfläche genützt werden, da die Biegefähigkeit aufgrund der geringeren Dicke größer ist. Werden der erste und der zweite Halbleiterchip 4, 5 bis an den Rand des Versteifungsrings 17 ausgeführt, ist eine gegenüber dem Stand der Technik wesentlich höhere Anzahl an Bauelementen realisierbar.

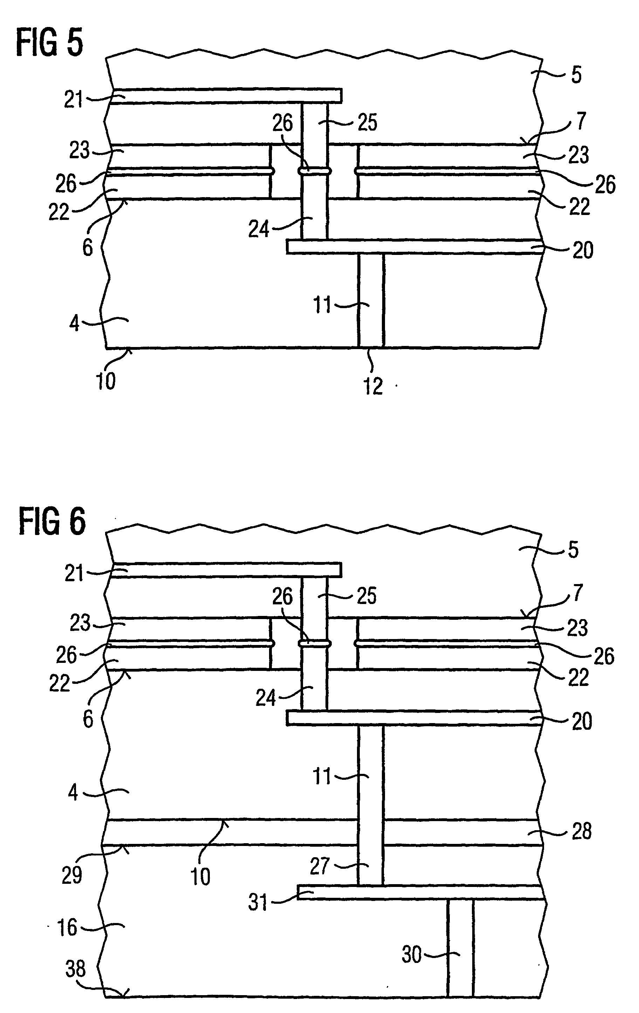

In den Figuren 5 und 6 soll das Prinzip der dreidimensionalen Verdrahtung näher verdeutlicht werden, wobei dort jeweils Ausschnitte aus den benachbart zueinander liegenden Hauptflächen der Halbleiterchips dargestellt sind.

Der erste Halbleiterchip 4 umfaßt im Bereich einer ersten Hauptfläche 6 Schaltungsstrukturen, die Bestandteil einer mikroelektronischen Schaltung oder einer optoelektronischen Komponente oder einer Sensorkomponente sind. Die Schaltungsstrukturen, die im einzelnen in Figur 5 nicht dargestellt sind, umfassen mindestens eine Metallisierungsebene 20, die durch isolierendes Material, z.B. SiO₂ (nicht dargestellt) gegenüber dem ersten Halbleiterchip 4 isoliert ist. Auf die erste Metallisierungsebene 20 reicht von der ersten Hauptfläche 6 her ein erster Kontakt 24. Auf der ersten Hauptfläche 6 sind erste Metallflächen 22 angeordnet, die z.B. durch ganzflächige CVD-Abscheidung von Wolfram und anschließende Strukturierung gebildet werden.

Ein zweiter Halbleiterchip 5 umfaßt im Bereich einer zweiten Hauptfläche 7 Schaltungsstrukturen, die ebenfalls Bestandteil einer mikroelektronischen Schaltung, einer optoelektronischen Komponente oder einer Sensorkomponente sind. Diese nichtdargestellten Schaltungsstrukturen umfassen mindestens eine zweite Metallisierungsebene 21, die durch isolierendes Material, z.B. SiO₂ (nicht dargestellt) gegenüber dem zweiten Halbleiterchip 5 isoliert ist. Von der zweiten Hauptfläche 7 her reicht ein zweiter Kontakt 25 auf die zweite Metallisierungsebene 21. Auf der zweiten Hauptfläche 7 sind zweite Metallflächen 23 angeordnet, die z.B. durch Abscheidung und anschließende Strukturierung einer Kupferschicht gebildet werden.

Der erste Halbleiterchip 4 und der zweite Halbleiterchip 5 werden so zusammengefügt, daß die ersten Metallisierungsflächen 22 auf die zweiten Metallisierungsflächen 23 treffen und daß der erste Kontakt 24 auf den zweiten Kontakt 25 trifft. Zwischen die Metallflächen 22, 23 und die Kontakte 24, 25 wird eine Lötschicht 26, z.B. aus Zinn aufgebracht. Durch Erhitzen der Anordnung auf etwa 200°c werden die Metallflächen 22, 23 und die Kontakte 24, 25 miteinander verlötet. Über die Kontakte 24, 25 kommt es zu einer elektrischen Verbindung zwischen den Schaltungsstrukturen im ersten Halbleiterchip 4 und im zweiten Halbleiterchip 5. Über die verlöteten Metallflächen 22, 23 kommt es zu einer festen mechanischen Verbindung zwischen beiden Substraten. Die Metallflächen 22, 23 stellen sogleich den Abtransport der wegen der hohen Pakkungsdichte beträchtlichen Verlustwärme sicher.

Soll dem aus dem ersten Halbleiterchip 4 und dem zweiten Halbleiterchip 5 gebildeten Stapel ein weiteres Bauelement hinzugefügt werden, muß zumindest einer der beiden Halbleiterchips gedünnt werden. Um eine möglichst geringe Höhe und Biegefähigkeit des Chipstapels zu erlangen, werden vorteilhafterweise beide Halbleiterchips auf ihrer Rückseite dünn geschliffen. Im vorliegenden Beispiel wird der erste Halbleiterchip 4 an der der ersten Hauptfläche 6 gegenüberliegende Rückseite 10 dünn geschliffen, bis die Dicke des ersten Substrats 5 bis 20µm, vorzugsweise 10µm, beträgt. Um die elektrische Verbindung zwischen einem der beiden Halbleiterchips und dem Kontaktelement in dreidimensionaler Verdrahtung herstellen zu können, ist ebenfalls ein Dünnschleifen eines Halbleiterchips notwendig.

Zur Herstellung der elektrischen Verbindung der Halbleiterchips mit dem Kontaktelement 15 wird von der Rückseite 10 her ein Rückseitenkontakt 11 auf die erste Metallisierungsebene 20 gebildet. Dazu wird ein Kontaktloch 11 geätzt, das mit einer Metallisierung, z.B. aus Wolfram aufgefüllt wird.

Der aus dem ersten Halbleiterchip 4 und dem zweiten Halbleiterchip 5 gebildete Stapel kann anschließend mit einem dritten Halbleiterchip 16 zusammengefügt werden (siehe Figur 6). Der dritte Halbleiterchip 16 ist auf der der dritten Hauptfläche 29 zugewandten Seite prinzipiell identisch aufgebaut wie der erste bzw. der zweite Halbleiterchip 4, 5. Der dritte Halbleiterchip 16 wird mit dem aus dem ersten Halbleiterchip 4 und dem zweiten Halbleiterchip 5 gebildeten Stapel so zusammengefügt, daß die dritte Hauptfläche 29 auf die Rückseite 10 des ersten Halbleiterchips 4 trifft. Dabei trifft ein dritter Kontakt 27 auf den Rückseitenkontakt 11 des ersten Halbleiterchips 4. Außerhalb des dritten Kontakts 27 und des Rückseitenkontaktes 11 wird eine Haftschicht 28, z.B. aus Polyimid aufgebracht, über die der dritte Halbleiterchip 16 fest mit dem ersten Halbleiterchip 4 verbunden wird. Der dritte Kontakt 27 und der Rückseitenkontakt 11 sind durch direktes Aufeinandertreffen der Kontakte elektrisch miteinander verbunden.

Der dritte Halbleiterchip 16 wird von einer der dritten Hauptfläche 29 gegenüberliegenden Rückseite 32 her bis auf 5 bis 20µm dünngeschliffen. Anschließend wird ein Rückseitenkontakt 30 von der Rückseite 32 auf eine dritte Metallisierungsebene 31 gebildet. Der Rückseitenkontakt 30 kann als Anschluß zu der dreidimensionalen Schaltungsanordnung verwendet werden, also mit dem Kontaktelement 15 des Moduls 13 verbunden werden. Der Rückseitenkontakt 30 könnte auch als vertikaler Kontakt zu einer weiteren hinzu zu fügenden Bauelementebene dienen.

Das erfindungsgemäße Vorgehen ermöglicht somit eine Chipkartenanordnung, die gegenüber den aus dem Stand der Technik bekannten Anordnungen eine wesentlich höhere Integrationsdichte aufweist und mit den üblichen Fertigungsmethoden hergestellt werden kann.

## Patentansprüche

1. Chipkartenanordnung mit einem kartenförmigen Träger (2), in dem eine Ausnehmung (3) vorgesehen ist, in der zumindest zwei übereinanderliegende Halbleiterchips (4, 5) angeordnet sind, die miteinander über elektrisch leitende Verbindungen (24, 25, 27, 11, 30) elektrischer Signale und/oder Energie austauschen, wobei
- der erste Halbleiterchip (4) eine erste Hauptfläche aufweist und im Bereich dieser ersten Hauptfläche (6) mindestens ein erstes Halbleiterbauelement mit der ersten Verbindung (24) und der zweite Halbleiterchip (5) eine zweite Hauptfläche aufweist und im Bereich dieser zweiten Hauptfläche (7) mindestens ein zweites Halbleiterbauelement mit der zweiten Verbindung (25) aufweist,
**dadurch gekennzeichnet, daß** der erste und der zweite Halbleiterchip (4, 5) so zu einem Stapel zusammengefügt sind, daß die erste Hauptfläche (6) auf die zweite Hauptfläche (7) trifft, so daß mindestens eine erste Verbindung (24) und eine zweite Verbindung (25) aufeinandertreffen und zusammen eine dreidimensionale Verdrahtung innerhalb des Stapels ausbilden und
- die Summe der Flächen beider Halbleiterchips (4, 5) mindestens 20 mm² beträgt.

2. Chipkartenanordnung nach Anspruch 1,
**dadurch gekennzeichnet, daß**
in der der ersten Hauptfläche (6) gegenüberliegenden Rückseite (10) des ersten Halbleiterchips (4) Kontaktlöcher (11) zur Bildung von Rückseitenkontakten (12) vorgesehen sind, die mit elektrischen Anschlüssen des kartenförmigen Trägers verbunden sind.

3. Chipkartenanordnung nach Anspruch 1 oder 2,
**dadurch gekennzeichnet, daß**
die Funktionsfähigkeit der Chipkartenanordnung nur dann gewährleistet ist, wenn die zumindest zwei Halbleiterchips (4, 5) elektrisch miteinander verbunden sind.

4. Chipkartenanordnung nach Anpruch 1,
**dadurch gekennzeichnet, daß**
der Stapel aus übereinanderliegenden Halbleiterchips (4, 5) eine Höhe von maximal 200µm aufweist.

5. Chipkartenanordnung nach einem der Ansprüche 1 bis 4,
**dadurch gekennzeichnet, daß**
die übereinanderliegenden Halbleiterchips (4, 5, 16) in einem Modul mit einem Kontaktelemente (15) aufweisenden Trägerelement angeordnet und elektrisch mit den Kontaktelementen (15) verbunden sind, wobei das Modul (13) in die Ausnehmung (3) des kartenförmigen Trägers (2) eingebracht ist.

## Claims

1. Chip card arrangement with a card-like carrier (2), in which there is provided a recess (3) in which at least two semiconductor chips (4, 5) lying one on top of the other are arranged and exchange electrical signals and/or energy with one another via electrically conducting connections (24, 25, 27, 11, 30),
- the first semiconductor chip (4) having a first main area and, in the region of this first main area (6), at least a first semiconductor component with the first connection (24), and the second semiconductor chip (5) having a second main area and, in the region of this second main area (7), at least a second semiconductor component with the second connection (25),
**characterized in that** the first and second semiconductor chips (4, 5) are joined together to form a stack in such a way that the first main area (6) meets the second main area (7), so that at least a first connection (24) and a second connection (25) meet each other and together form a three-dimensional wiring within the stack and
- the sum of the surface areas of the two semiconductor chips (4, 5) is at least 20 mm².

2. Chip card arrangement according to Claim 1, **characterized in that** contact holes (11) for the forming of rear-side contacts (12), which are connected to electrical terminals of the card-like carrier, are provided in the rear side (10) of the first semiconductor chip (4), opposite from the first main area (6).

3. Chip card arrangement according to Claim 1 or 2, **characterized in that** the functional capability of the chip card arrangement is only ensured when the at least two semiconductor chips (4, 5) are electrically interconnected.

4. Chip card arrangement according to Claim 1, **characterized in that** the stack of semiconductor chips (4, 5) lying one on top of the other has a maximum height of 200 µm.

5. Chip card arrangement according to one of Claims 1 to 4, **characterized in that** the semiconductor chips (4, 5, 16) lying one on top of the other are arranged in a module with a carrier element having contact elements (15) and are electrically connected to the contact elements (15), the module (13) having been inserted into the recess (3) of the card-like carrier (2).

## Revendications

1. Dispositif à carte à puce comprenant un support (2) en forme de carte, dans lequel est prévu un évidement (3) dans lequel sont placées au moins deux puces (4, 5) à semi-conducteur superposées qui échangent entre elles des signaux électriques et/ou de l'énergie par des liaisons (24, 25, 27, 11, 30) conductrices de l'électricité, dans lequel
- la première puce (4) à semi-conducteur a une première surface principale et, dans la région de cette première surface (6) principale, au moins un premier composant à semi-conducteur ayant la première liaison (24), et la deuxième puce (5) à semi-conducteur a une deuxième surface principale et, dans la région de cette deuxième surface (7) principale, au moins un deuxième composant à semi-conducteur ayant la deuxième liaison (25),
**caractérisé en ce que** la première et la deuxième puce (4, 5) à semi-conducteur sont assemblées en une pile, de façon à ce que la première surface (6) principale vienne sur la deuxième surface (7) principale, de façon à ce qu'au moins une première liaison (24) et une deuxième liaison (25) forment, en venant l'une sur l'autre et ensemble, un câblage tridimensionnel à l'intérieur de la pile et
- la somme des deux surfaces des deux puces (4, 5) à semi-conducteur est d'au moins 20 mm².

2. Dispositif à carte à puce suivant la revendication 1,
**caractérisé en ce qu'**il est prévu pour la formation de contacts (12) de face arrière, dans la patte (10) arrière opposée à la première surface (6) principale de la première puce (4) à semi-conducteur, des trous de contact qui sont reliés à des bornes électriques du support en forme de carte.

3. Dispositif à carte à puce suivant la revendication 1 ou 2,
**caractérisé en ce que** l'aptitude à fonctionner du dispositif à carte à puce n'est assurée que si les au moins deux puces (4, 5) à semiconducteurs sont reliées entre elles du point de vue électrique.

4. Dispositif à carte à puce suivant la revendication 1,
**caractérisé en ce que** la pile de puces (4, 5) à semi-conducteur superposées a une hauteur d'au plus 200 µm.

5. Dispositif à carte à puce suivant l'une des revendications 1 à 4,
**caractérisé en ce que** les puces (4, 5, 16) à semi-conducteur superposées sont placées dans un module ayant un élément support comportant des éléments (15) de contact et sont reliées du point de vue électrique aux éléments (15) de contact, le module (13) étant logé dans l'évidement (3) du support (2) en forme carte.
